# EUROPEAN PATENT APPLICATION

(11) **EP 2 675 250 A1**
(43) Date of publication of application: **18.12.2013**
(21) Application number: 12744194.7
(22) Date of filing: 18.01.2012
(51) Int. Cl.: H05H 1/24, B01J 19/08, B08B 3/08, C01B 13/11

(54) **PLASMA GENERATOR, CLEANING AND PURIFYING DEVICE USING THE PLASMA GENERATOR, AND SMALL-SIZED ELECTRICAL APPARATUS**

(30) Priority: 08.02.2011 JP 2011024931
(71) Applicant: Panasonic Corporation, Osaka 571-8501 (JP)
(72) Inventor: SAITOH, Akihiko, Osaka-shi, Osaka 540-6207 (JP); SANEMATSU, Wataru, Osaka-shi, Osaka 540-6207 (JP); NARITA, Kenji, Osaka-shi, Osaka 540-6207 (JP); MACHI, Masaharu, Osaka-shi, Osaka 540-6207 (JP)
(74) Representative: Grünecker, Kinkeldey, Stockmair & Schwanhäusser
(86) International application number: PCT/JP2012/050890
(87) International publication number: WO 2012/108235

(57) **Abstract**

A plasma generator 1 includes: a liquid storage section 4 that stores a liquid containing water; a gas storage section 5 that stores a gas; a partition 3 provided with a gas passage 3a to introduce the gas in the gas storage section 5 into the liquid storage section 4 and separating the liquid storage section 4 from the gas storage section 5; a first electrode 12 provided in the gas storage section 5; and a second electrode 13 separated from the first electrode 12 and provided in a manner such that at least the portion coupled with the first electrode 12 is in contact with the liquid in the liquid storage section 4. A predetermined voltage is applied between the first electrode 12 and the second electrode 13 while the second electrode 13 is grounded.

## Description

### TECHNICAL FIELD

The present invention relates to a plasma generator, and a cleaning and purifying apparatus and a small-sized electrical appliance each using the plasma generator.

### BACKGROUND ART

There are known apparatuses to produce a radical and the like in bubbled contained in a liquid by causing electric discharge in the liquid so as to reform the liquid (for example, refer to Patent Document 1).

### CITATION LIST

### PATENT LITERATURE

Patent Document 1: Japanese Patent Unexamined Publication No. 2001-009463

### SUMMARY OF INVENTION

However, there is no information about the safety of the conventional apparatuses.

It is an object of the present invention to obtain a plasma generator capable of surely ensuring safety, and a cleaning and purifying apparatus and a small-sized electrical appliance each using the plasma generator.

A first aspect of the present invention is a plasma generator, comprising: a liquid storage section that stores a liquid containing water; a gas storage section that stores a gas; a partition provided with a gas passage to introduce the gas in the gas storage section into the liquid storage section, and separating the liquid storage section from the gas storage section; a first electrode provided in the gas storage section; a second electrode separated from the first electrode and provided in a manner such that at least a portion coupled with the first electrode is in contact with the liquid in the liquid storage section; a gas supply unit that supplies a gas containing oxygen to the gas storage section so that the gas in the gas storage section is delivered under pressure into the liquid storage section via the gas passage; and a plasma power source that applies a predetermined voltage between the first electrode and the second electrode while the second electrode is grounded to cause electric discharge between the first electrode and the second electrode, and thereby convert the gas introduced into the gas storage section into plasma.

According to a second aspect of the present invention, more than one gas passage is provided in the partition.

According to a third aspect of the present invention, the first electrode is placed to be substantially the same distance from each gas passage.

According to a fourth aspect of the present invention, the first electrode is composed of a single structure.

According to a fifth aspect of the present invention, the first electrode composed of a single structure is placed in direct contact with the partition on the gas storage section side.

According to a sixth aspect of the present invention, the first electrode is located on the axis of the gas passage so as to face the gas passage.

A seventh aspect of the present invention is a cleaning and purifying apparatus comprising the plasma generator.

An eighth aspect of the present invention is a small-sized appliance comprising the plasma generator.

A ninth aspect of the present invention is a small-sized appliance comprising the cleaning and purifying apparatus.

In the plasma generator according to the present invention, a predetermined voltage is applied between the first electrode and the second electrode while the second electrode is grounded. This configuration protects a user from electrical shock even if the user accidentally touches the liquid or the second electrode. Namely, the plasma generator according to the present invention can surely ensure safety.

Safe operation of a cleaning and purifying apparatus and a small-sized appliance can be obtained by providing the cleaning and purifying apparatus and the small-sized appliance with the plasma generator described above.

### BRIEF DESCRIPTION OF DRAWINGS

[FIG. 1] FIG. 1 is a schematic partial cross-sectional view showing a configuration of a plasma generator according to a first embodiment of the present invention.
[FIG. 2] FIG. 2 is a graph showing a level of a voltage applied to a first electrode and a second electrode of the plasma generator according to the first embodiment of the present invention.
[FIG. 3] FIG. 3 is a partially enlarged cross-sectional view schematically showing a particular situation to explain the performance of the plasma generator according to the first embodiment of the present invention.
[FIG. 4] FIG. 4 is a partially enlarged cross-sectional view schematically showing a situation following the situation shown in FIG. 3.
[FIG. 5] FIG. 5 is a schematic partial cross-sectional view showing a configuration of a plasma generator according to a first modified example of the first embodiment of the present invention.
[FIG. 6] FIG. 6 is a schematic partial cross-sectional view showing a configuration of a plasma generator according to a second modified example of the first embodiment of the present invention.
[FIG. 7] FIG. 7 is a schematic partial cross-sectional view showing a configuration of a plasma generator according to a third modified example of the first embodiment of the present invention.
[FIG. 8] FIG. 8 is a schematic view showing the positional relationship between a partition and a first electrode according to a fourth modified example of the first embodiment of the present invention.
[FIG. 9] FIG. 9 is a schematic partial cross-sectional view showing a configuration of a plasma generator according to a fifth modified example of the first embodiment of the present invention.
[FIG. 10] FIG. 10 is a back view of a partition of the plasma generator according to the fifth modified example of the first embodiment of the present invention, as viewed from a gas supply unit.
[FIG. 11] FIG. 11 is a schematic partial cross-sectional view showing a configuration of a plasma generator according to a sixth modified example of the first embodiment of the present invention.
[FIG. 12] FIG. 12 is a perspective view showing a specific example of a small-sized appliance including a plasma generator according to a second embodiment of the present invention.
[FIG. 13] FIG. 13 is a side cross-sectional view of the small-sized appliance shown in FIG. 12.
[FIG. 14] FIG. 14 is a schematic partial cross-sectional view showing the plasma generator according to the second embodiment of the present invention.
[FIG. 15] FIG. 15 is a cross-sectional view taken along the line A-A in FIG. 13.
[FIG. 16] FIG. 16 is a schematic partial cross-sectional view showing a configuration of a cleaning and purifying apparatus according to a third embodiment of the present invention.
[FIG. 17] FIG. 17 is a side cross-sectional view showing a small-sized appliance according to a fourth embodiment of the present invention.

### DESCRIPTION OF EMBODIMENTS

Hereinafter, embodiments according to the present invention will be explained with reference to the drawings. Note that the respective embodiments described below include the common elements indicated by the common reference numerals, and overlapping explanations thereof are not repeated.

### (First embodiment)

A plasma generator 1 according to the present embodiment includes a case member 2 formed in a substantially cylindrical shape. Note that the case member is not limited to the cylindrical shape, and it may be formed in a prism.

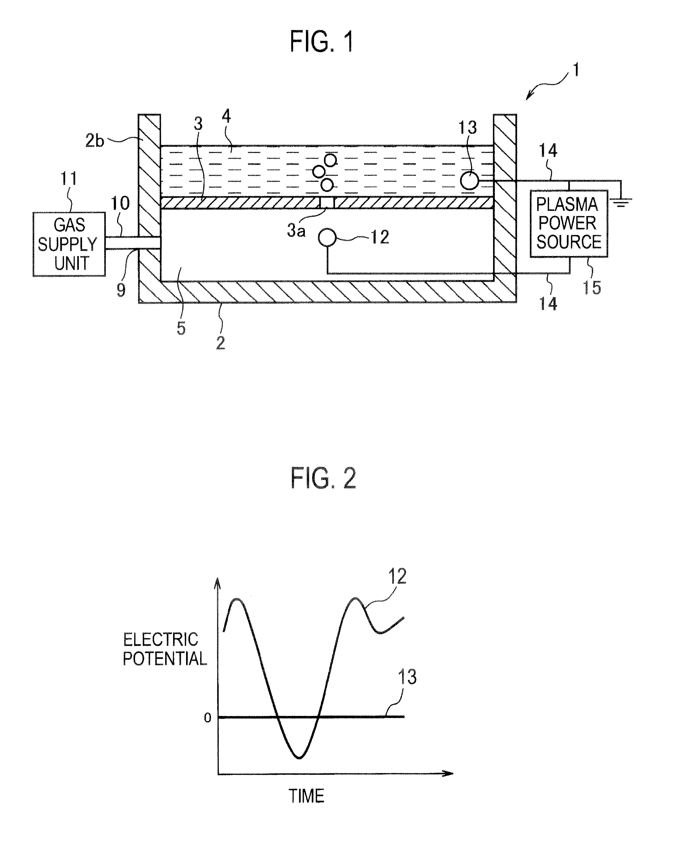

As shown in FIG. 1, a ceramic member 3 is provided inside of the case member 2 to divide the case member 2 into an upper area and a lower area.

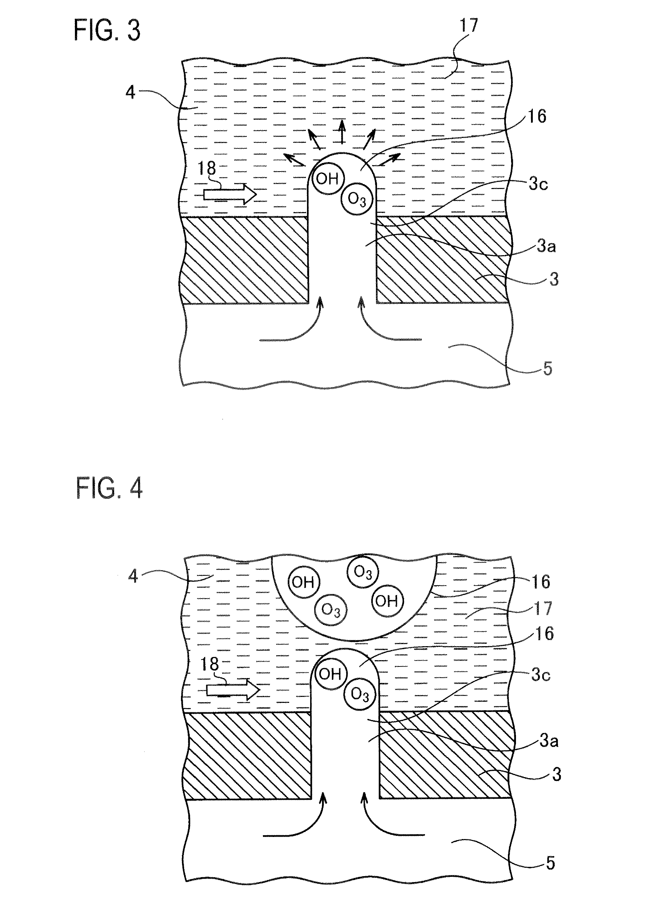

In the present embodiment, the upper area in the inner space of the case member 2 divided by the ceramic member 3 serves as a liquid storage section 4 to store a liquid 17 containing water (refer to FIG. 3 and FIG.. 4), and the lower area serves as a gas storage section 5 to store a gas.

As described above, the ceramic member 3 according to the present embodiment serves as a partition to separate the liquid storage section 4 from the gas storage section 5.

A gas inlet 9 is provided at the bottom of the side wall 2b of the case member 2 so that the gas storage section 5 communicates with the outside. A pipe (a gas introduction passage) 10 is inserted into the gas inlet 9. The gas storage section 5 is connected to a gas supply unit 11 via the pipe 10. In the present embodiment, a gas containing at least oxygen (O2) is supplied to the gas storage section 5 from the gas supply unit 11.

The ceramic member 3 is provided with a gas passage 3a through which the gas introduced into the gas storage section 5 from the gas supply unit 11 is delivered to the liquid storage section 4.

The gas supply unit 11 according to the present embodiment thus functions to supply the gas containing at least oxygen to the gas storage section 5 in a manner such that the gas in the gas storage section 5 is delivered under pressure to the liquid storage section 4 via the gas passage 3a.

In the present embodiment, the diameter of the hole in the gas passage 3a is set approximately in the range from 1 µm to 10 µm so as to prevent the liquid 17 stored in the liquid storage section 4 from leaking from the gas passage 3a into the gas storage section 5.

The plasma generator 1 includes a first electrode 12 provided in the gas storage section 5, and a second electrode 13 separated from the first electrode 12 and provided in such a manner that at least the portion coupled with the first electrode 12 (a surface of the second electrode 13 arranged to generate electric discharge to a surface of the first electrode 12) is in contact with the liquid 17 in the liquid storage section 4.

In particular, the substantially spherical first electrode 12 and the substantially spherical second electrode 13 are provided in the gas storage section 5 and in the liquid storage section 4, respectively.

As shown in FIG. 1, the substantially spherical first electrode 12 is located adjacent to the gas passage 3a of the ceramic member 3 in the gas storage section 5. The surface of the first electrode 12 is covered with a dielectric material (not shown in the figure).

The second electrode 13 is provided in the liquid storage section 4 in such a manner that at least the portion coupled with the first electrode 12 (the surface of the second electrode 13 arranged to generate electric discharge to the surface of the first electrode 12) is in contact with the liquid 17 in the liquid storage section 4. The second electrode 13 is located adjacent to the interior side surface of the liquid storage section 4 in the case member 2.

The first electrode 12 is provided in the gas storage section 5 so as to be prevented from coming into contact with the liquid 17 introduced into the liquid storage section 4.

The second electrode 13 is provided in the liquid storage section 4 in such a manner that at least the portion coupled with the first electrode 12 (the surface of the second electrode 13 arranged to generate electric discharge to the surface of the first electrode 12) is in contact with the liquid 17 introduced into the liquid storage section 4.

The first electrode 12 and the second electrode 13 are each electrically connected to a plasma power source 15 via leads 14 (refer to FIG. 1), so that a predetermined voltage is applied between the first electrode 12 and the second electrode 13.

In the present embodiment, the predetermined voltage is applied between the first electrode 12 and the second electrode 13 while the second electrode 13 is grounded.

Next, the performance of the plasma generator 1 and the method for producing hydroxyl radical are explained below.

First, a gas containing oxygen is supplied to the gas storage section 5 in a manner such that the gas in the gas storage section 5 is delivered under pressure to the liquid storage section 4 via the gas passage 3a (a step of supplying a gas).

In the present embodiment, as shown in FIG. 1, the gas containing oxygen based on air (the flow rate is approximately in the range from 0.01 L/min to 1.0 L/min (in the range from 10 cc/min to 1000 cc/min)) is delivered to the gas storage section 5 from the gas supply unit 11 via the pipe 10. In this case, the pressure to deliver the gas is set approximately in the range from 0.0098 MPa to 0.49 MPa (in the range from 0.1 kgf/cm2 to 5 kgf/cm2).

As described above, the gas supply unit 11 functions to supply the gas (air) in the atmosphere. Here, the flow rate of the gas supplied is controlled by a flow rate controller (not shown in the figures) provided in the gas supply unit 11. Alternatively, the gas supply unit 11 may function to supply several types of gases (for example, gases having different oxygen concentrations) in addition to the gas in the atmosphere, and may be provided with a gas-type regulator to selectively supply one of or some of the several types of gases.

When the gas is supplied to the gas storage section 5, the pressure in the gas storage section 5 is changed approximately to the range from 0.11 MPa to 0.59 MPa (from 1.1 kgf/cm2 to 6 kgf/cm2) due to the increased pressure (in addition to the atmospheric pressure), so that the gas storage section 5 is in a state of positive pressure. The positive pressure in the gas storage section 5 causes a flow of the gas toward the liquid storage section 4 from the gas storage section 5 through the gas passage 3a. The positive pressure in the gas storage section 5 also contributes to preventing the liquid 17 stored in the liquid storage section 4 from leaking into the gas storage section 5 through the gas passage 3a.

As shown in FIG. 3, when the gas containing oxygen is supplied to the gas storage section 5 as described above, fine gas bubbles 16 containing oxygen are developed at the opening end 3c of the gas passage 3a on the liquid storage section 4 side (the upper side in FIG. 1) (a step of developing gas bubbles).

Then, a predetermined voltage is applied between the first electrode 12 and the second electrode 13 by the plasma power source 15. The applied voltage is preferably capable of glow discharge under atmospheric pressure (power: approximately from 10 W to 100 W). In this case, it is preferable to provide a voltage controller in the plasma power source 15 so as to control the voltage applied between the first electrode 12 and the second electrode 13.

Once the predetermined voltage is applied between the first electrode 12 and the second electrode 13, electric discharge is caused between the first electrode 12 and the second electrode 13 in a gas atmosphere under atmospheric pressure or higher. Here, a method for producing plasma under atmospheric pressure has been reported in, for example, Document A (Sachiko Okazaki, "Atmospheric Pressure Glow Discharge Plasma and Its Applications", Review Speech: 20th JSPF Annual Meeting).

The electric discharge (the discharge caused between the surface of the first electrode 12 in contact with the gas and the surface of the second electrode 13 in contact with the liquid) produces plasma in the gas region in the liquid 17 in the liquid storage section 4, so as to produce ozone and hydroxyl radical from water contained in the liquid or oxygen contained in the gas (a step of producing hydroxyl radical).

According to the present embodiment, a potential difference is caused in the gas inside the gas bubbles 16 (the gas present around the gas-liquid boundary in the liquid 17 in the liquid storage section 4) so as to produce the plasma. The potential difference caused around the gas-liquid boundary (adjacent to the opening end 3c of the gas passage 3a facing the liquid 17) where the hydroxyl radical is easily produced, can produce a larger amount of ozone and hydroxyl radical. Note that, in the present embodiment, the ozone and hydroxyl radical can be produced also in the gas bubbles 16 delivered into the liquid storage section 4 in addition to the gas bubbles 16 present adjacent to the opening end 3c of the gas passage 3a facing the liquid 17.

The ozone and hydroxyl radical thus produced are delivered to the liquid storage section 4 in association with the gas flow described above.

According to the present embodiment, the gas bubbles 16 containing the hydroxyl radical and the like are separated from the ceramic member (the partition) 3 and then released into the liquid 17 by the flow of the liquid 17 in the liquid storage section 4 (a step of releasing gas bubbles).

In particular, the liquid 17 is introduced to the liquid storage section 4 where the gas bubbles 16 are developed, so as to generate the flow of the liquid 17 (refer to arrow 18 in FIG. 3 and FIG. 4). As shown in FIG. 4, when the liquid 17 flowing in the direction of the arrow 18 hits the gas bubbles 16 being developed, the gas bubbles 16 are subjected to a separation force caused by the flow of the liquid 17 and are thereby released into the liquid 17 from the opening end 3c.

Since the gas bubbles 16 released into the liquid 17 are fine gas bubbles, the released gas bubbles 16 are dispersed in the liquid 17 in all directions without being emitted immediately into the atmosphere. A number of the dispersed fine gas bubbles 16 are easily dissolved in the liquid 17. At this point, the ozone contained in the gas bubbles 16 is dissolved into the liquid 17 and as a result, the ozone concentration in the liquid 17 is immediately increased.

Here, Document B (Masayoshi Takahashi, "Improvement in Aquatic Environment by Microbubbles and Nanobubbles"; Aquanet, 2004. 6) has reported that the fine gas bubbles 16 containing the ozone and several types of radicals generally tend to be negatively-charged. Therefore, a number of the gas bubbles 16 easily adhere to materials such as organic substances, oil and fat substances, dyes, proteins and bacteria (not shown in the figures) contained in the liquid 17. The organic substances and the like in the liquid 17 are resolved by the ozone or several types of radicals dissolved in the liquid 17, or by the ozone or several types of radicals contained in the gas bubbles 16 adhering to the organic substances and the like.

For example, the hydroxyl radical has relatively high energy that is approximately 120 kcal/mol. Such energy is greater than bond energy (up to 100 kcal/mol) of a double bond between nitrogen atoms (N=N) , a double bond between carbon atoms (C=C), or a double bond between a nitrogen atom and a carbon atom (N=C). Therefore, the organic substances produced by the bond of nitrogen and/or carbon are resolved since the bond in the organic substances is easily broken by the hydroxyl radical. Here, the ozone and hydroxyl radical contributing to such a resolution of the organic substances are environmentally-friendly substances since the ozone and hydroxyl radical are not persistent (unlike chlorine and the like) but disappear with time.

As explained above, the plasma generator 1 according to the present embodiment is provided with the first electrode 12 in the gas storage section 5, and provided with the second electrode 13 in such a manner that at least the portion coupled with the first electrode 12 (the surface of the second electrode 13 arranged to generate electric discharge to the surface of the first electrode 12) is in contact with the liquid 17 in the liquid storage section 4.

The plasma is produced in the gas region inside the liquid 17 in the liquid storage section 4 by causing the electric discharge between the surface of the first electrode 12 in contact with the gas and the surface of the second electrode 13 in contact with the liquid, so that the hydroxyl radical is produced from water contained in the liquid 17 and oxygen contained in the gas.

According to the configuration described above, the electric discharge can be caused between the first electrode 12 and the second electrode 13 without being influenced largely by the electrical resistance of the liquid 17 and therefore, the gas can be converted into plasma more reliably. Accordingly, a large amount of ozone and radical can be produced more stably.

According to the present embodiment, the predetermined voltage is applied between the first electrode 12 and the second electrode 13 while the second electrode 13 is grounded. This configuration protects the user from electrical shock even if the user accidentally touches the liquid or the second electrode.

Thus, the plasma generator according to the present embodiment can secure the safety of the user more reliably.

According to the present embodiment, the liquid 17 is introduced into the liquid storage section 4, and the first electrode 12 for producing plasma is provided in the gas storage section 5 that is defined by the ceramic member 3. Therefore, the first electrode 12 does not come into contact with the liquid 17 and is not influenced by the electrical resistance of the liquid 17. As a result, the electric discharge can be stably caused between the first electrode 12 and the second electrode 13. Further, the ozone and hydroxyl radical can be stably produced from water and oxygen since the gas containing oxygen introduced into the gas storage section 5 is surely converted into plasma.

According to the present embodiment, the gas containing oxygen is introduced into the gas storage section 5, so that the gas storage section 5 is in the state of positive pressure, and the flow of the gas from the gas storage section 5 toward the liquid storage section 4 through the gas passage 3a is generated. The ozone and hydroxyl radical are produced inside the gas bubbles 16 developed at the opening end 3c of the gas passage 3a facing the liquid 17 in association with the gas flow.

Namely, in the present embodiment, the ozone and hydroxyl radical are produced in the gas which forms the gas bubbles 16 (the gas present around the gas-liquid boundary in the liquid 17 in the liquid storage section 4). The gas containing the ozone and hydroxyl radical is dispersed as the fine gas bubbles 16 in the liquid 17 in all directions. Accordingly, the ozone and several types of radicals can be delivered into the liquid 17 efficiently in quite a short period of time after the production but before the disappearance of the ozone and several types of radicals.

Since the fine gas bubbles 16 containing the ozone and several types of radicals are dispersed in the liquid 17 in all directions, the ozone concentration in the liquid 17 is increased, and the gas bubbles 16 adhere to the organic substances contained in the liquid 17. As a result, the organic substances or bacteria can be effectively resolved by the ozone dissolved in the liquid 17 and the several types of radicals contained in the gas bubbles 16 adhering to the organic substances.

Further, the electric discharge can be caused stably regardless of variations of the electrical resistance of the liquid 17 caused between the first electrode 12 and the second electrode 13, as long as the plasma power source 15 is provided with the voltage controller to control the voltage applied between the first electrode 12 and the second electrode 13.

When the gas supply unit 11 includes the gas-type regulator to regulate the type of the gas, the amount of the ozone and hydroxyl radical produced can be adjusted.

In this case, if the gas supply unit 11 functions to supply air in the atmosphere, the gas can be supplied more easily.

Further, if the flow rate controller controls the flow rate of the supplied gas, the plasma can be produced more stably.

The following is an explanation of a modified example of the plasma generator.

### (First modified example)

A plasma generator 1A according to this modified example has substantially the same constitution as the plasma generator 1 according to the first embodiment. That is, the plasma generator 1A includes the case member 2, and the ceramic member (the partition) 3 provided inside the case member 2 to divide it into the upper area and the lower area.

The upper area in the inner space of the case member 2 divided by the ceramic member 3 serves as the liquid storage section 4 to store the liquid 17 containing water, and the lower area serves as the gas storage section 5 to store the gas.

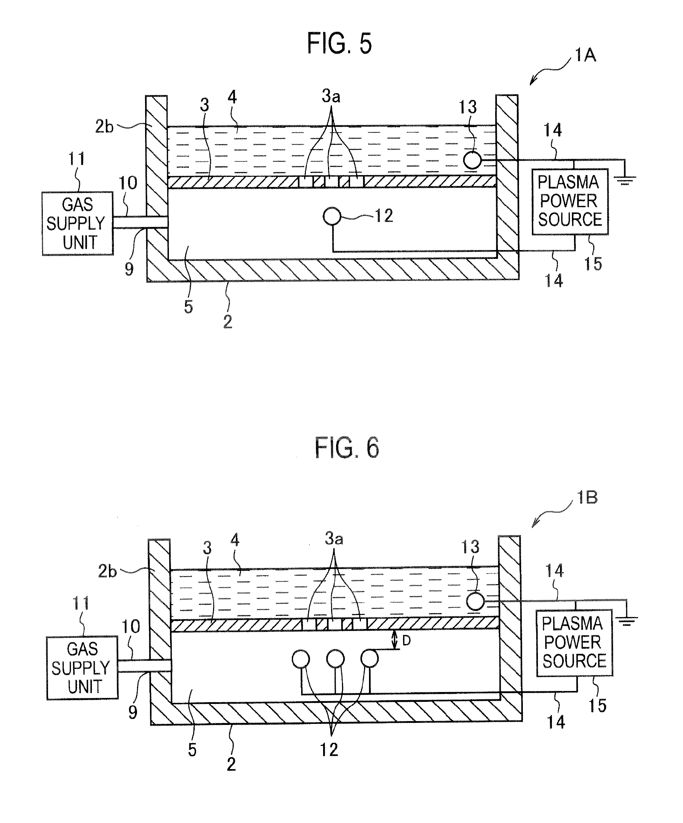

The plasma generator 1A according to this modified example differs from the plasma generator 1 according to the first embodiment in that the partition 3 is provided with plural gas passages 3a as shown in FIG. 5.

Although FIG. 5 shows three gas passages 3a in the partition 3, two or four or more of the gas passages 3a may be provided in the partition 3.

This modified example can achieve the same effects as the first embodiment.

According to this modified example, since the plural gas passages 3a are provided in the partition 3, the gas bubbles can be generated simultaneously in several areas (adjacent to the opening ends 3c of the plural gas passages 3a facing the liquid 17) so as to increase the amount of the generated plasma. As a result, a large amount of ozone and radicals can be produced.

### (Second modified example)

A plasma generator 1B according to this modified example has substantially the same constitution as the plasma generator 1 according to the first embodiment. That is, the plasma generator 1B includes the case member 2, and the ceramic member (the partition) 3 provided inside of the case member 2 to divide it into the upper area and the lower area.

The upper area in the inner space of the case member 2 divided by the ceramic member 3 serves as the liquid storage section 4 to store the liquid 17 containing water, and the lower area serves as the gas storage section 5 to store the gas.

The plasma generator 1B according to this modified example differs from the plasma generator 1 according to the first embodiment in that, as shown in FIG. 6, the partition 3 is provided with plural gas passages 3a (three in this modified example), and one or more first electrodes 12 (three in this modified example) are provided.

In this modified example, the three first electrodes 12 are placed in a manner as to be substantially the same distance D from the opening ends of the gas passages 3a on the gas storage section 5 side.

This modified example can also achieve the same effects as the first embodiment.

In this modified example, since the plural gas passages 3a are provided in the partition 3, and one or more first electrodes 12 are placed in a manner as to be substantially the same distance D from the respective gas passages 3a, the voltage can be applied to the gas bubbles generated in several areas. Namely, the electric discharge can be caused adjacent to the opening ends 3c of the respective gas passages 3a facing the liquid 17. As a result, the amount of the generated plasma can be increased, and the large amount of the ozone and radicals can be produced. Further, since the first electrodes 12 are placed in a manner as to be substantially the same distance D from the respective gas passages 3a, an imbalance of the discharge caused among the plural gas passages 3a can be prevented.

### (Third modified example)

A plasma generator 1C according to this modified example has substantially the same constitution as the plasma generator 1 according to the first embodiment. That is, the plasma generator 1C includes the case member 2, and the ceramic member (the partition) 3 provided inside of the case member 2 to divide it into the upper area and the lower area.

The upper area in the inner space of the case member 2 divided by the ceramic member 3 serves as the liquid storage section 4 to store the liquid 17 containing water, and the lower area serves as the gas storage section 5 to store the gas.

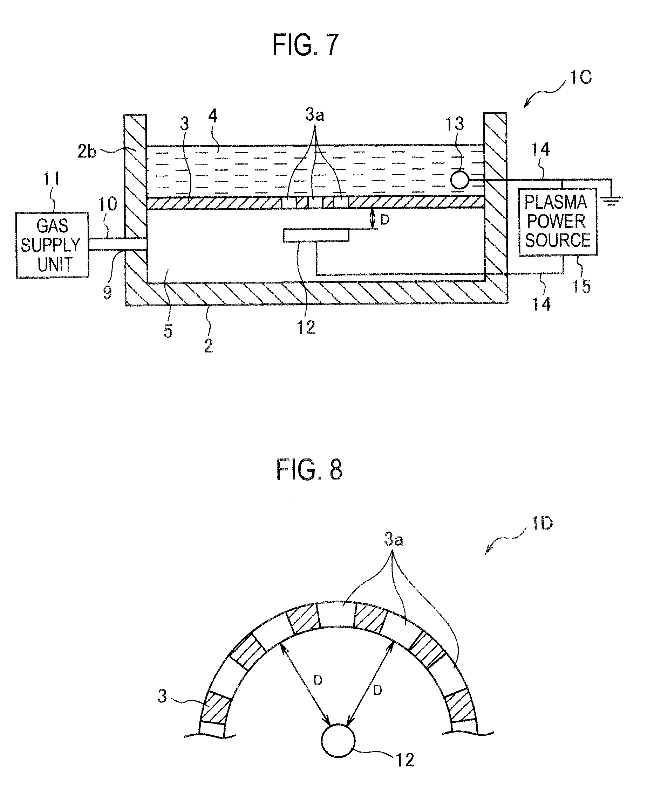

The plasma generator 1C according to this modified example differs from the plasma generator 1 according to the first embodiment in that, as shown in FIG. 7, the partition 3 is provided with plural gas passages 3a (three in this modified example), and the first electrode 12 is provided as a single structure.

In particular, the first electrode 12 is formed as a plate-like structure, and the largest surface thereof is arranged approximately to be in parallel with and to face the opening ends of the gas passages 3a on the gas storage section 5 side. Namely, the first electrode 12 according to this modified example is placed in a manner as to entirely be substantially the same distance D from the opening ends of the gas passages 3a on the gas storage section 5 side in the same manner as the second modified example.

This modified example can also achieve the same effects as the first embodiment and the second modified example.

Since the first electrodes 12 is composed of a single structure, this modified example contributes to simplification of the manufacturing process and reduction in cost.

### (Fourth modified example)

A plasma generator 1D according to this modified example has substantially the same constitution as the plasma generator 1 according to the first embodiment. That is, the plasma generator 1D includes the case member 2, and the ceramic member (the partition) 3 provided inside of the case member 2 to divide it into the upper area and the lower area.

The upper area in the inner space of the case member 2 divided by the ceramic member 3 serves as the liquid storage section 4 to store the liquid 17 containing water, and the lower area serves as the gas storage section 5 to store the gas.

The plasma generator 1D according to this modified example differs from the plasma generator 1 according to the first embodiment in that, as shown in FIG. 8, the partition 3 is provided with plural gas passages 3a (three in this modified example), and the first electrode 12 is provided as a single structure.

In particular, the first electrode 12 consists of a single spherical body located approximately in the center of the partition 3 having at least a substantially spherical shell part. In particular, the first electrode 12 is located approximately in the center of the substantially spherical shell partition 3 in a manner as to be substantially the same distance D from the opening ends of the gas passages 3a on the gas storage section 5 side. Here, the first electrode 12 may have a stick shape or a spherical shape provided along the axis of the cylindrical partition 3 so as to be substantially the same distance D from the opening ends of the gas passages 3a on the gas storage section 5 side.

This modified example can achieve the same effects as the third modified example.

### (Fifth modified example)

A plasma generator 1E according to this modified example has substantially the same constitution as the plasma generator 1 according to the first embodiment. That is, the plasma generator 1E includes the case member 2, and the ceramic member (the partition) 3 provided inside of the case member 2 to divide it into the upper area and the lower area.

The upper area in the inner space of the case member 2 divided by the ceramic member 3 serves as the liquid storage section 4 to store the liquid 17 containing water, and the lower area serves as the gas storage section 5 to store the gas.

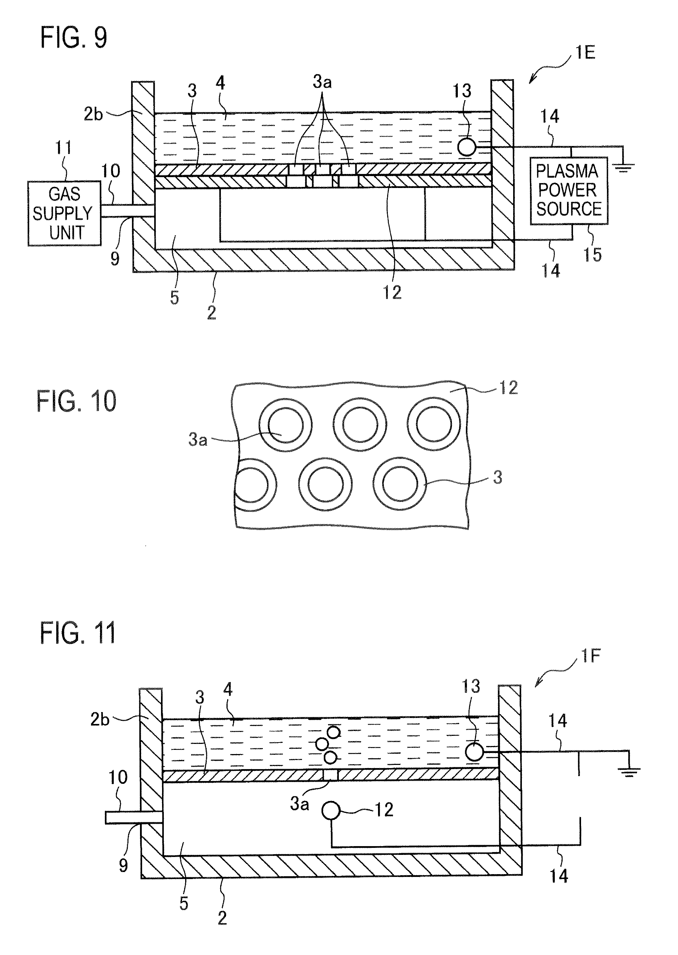

The plasma generator 1E according to this modified example differs from the plasma generator 1 according to the first embodiment in that, as shown in FIG. 9 and FIG. 10, the first electrode 12 composed of a single body is placed in direct contact with the partition 3 on the gas storage section 5 side.

In particular, the first electrode 12 is formed in a manner such that the surface of the partition 3 on the gas storage section 5 side is plated to form an electrode, and the electrode is then provided with deep counterbores corresponding to the gas passages 3a in a concentric manner. Namely, the first electrode 12 is substantially the same distance D from the opening ends of the gas passages 3a on the gas storage section 5 side in a manner as to provide the deep counterbores concentric with the gas passages 3a.

Although FIG. 9 and FIG. 10 show the deep counterbores having a larger diameter than the gas passages 3a, the counterbores may have the same diameter as or a smaller diameter than the gas passages 3a.

Alternatively, the gas passages 3a and the deep counterbores may be formed into a substantially truncated cone (tapered shape).

This modified example can also achieve the same effects as the first embodiment.

Since the first electrode 12 according to this modified example is a single structure formed by plating and provided with the deep counterbores, the first electrode 12 can be produced easily.

Further, the first electrode 12 composed of a single structure that is placed in direct contact with the partition 3 on the gas storage section 5 side, contributes to reducing the thickness of the generator.

### (Sixth modified example)

A plasma generator 1F according to this modified example has substantially the same constitution as the plasma generator 1 according to the first embodiment. That is, the plasma generator 1F includes the case member 2, and the ceramic member (the partition) 3 provided inside of the case member 2 to divide it into the upper area and the lower area.

The upper area in the inner space of the case member 2 divided by the ceramic member 3 serves as the liquid storage section 4 to store the liquid 17 containing water, and the lower area serves as the gas storage section 5 to store the gas.

The plasma generator 1E according to this modified example differs from the plasma generator 1 according to the first embodiment in that, as shown in FIG. 11, the first electrode 12 is located on an axis of the gas passage 3a so as to directly face it.

Although FIG. 11 shows one first electrode 12 and one gas passage 3a, this modified example may include plural first electrodes 12 and gas passages 3a.

This modified example can also achieve the same effects as the first embodiment.

In this modified example, the first electrode 12 placed to directly face the gas passage 3a can produce plasma along the shortest possible path. As a result, excessive electrodes can be eliminated, which results in cost reduction. Further, producing plasma along the shortest possible path shortens the distance between the first electrode 12 and the gas-liquid boundary. This reduces the voltage (the potential difference between the first electrode and the second electrode) and further achieves electric power saving of the generator.

### (Second embodiment)

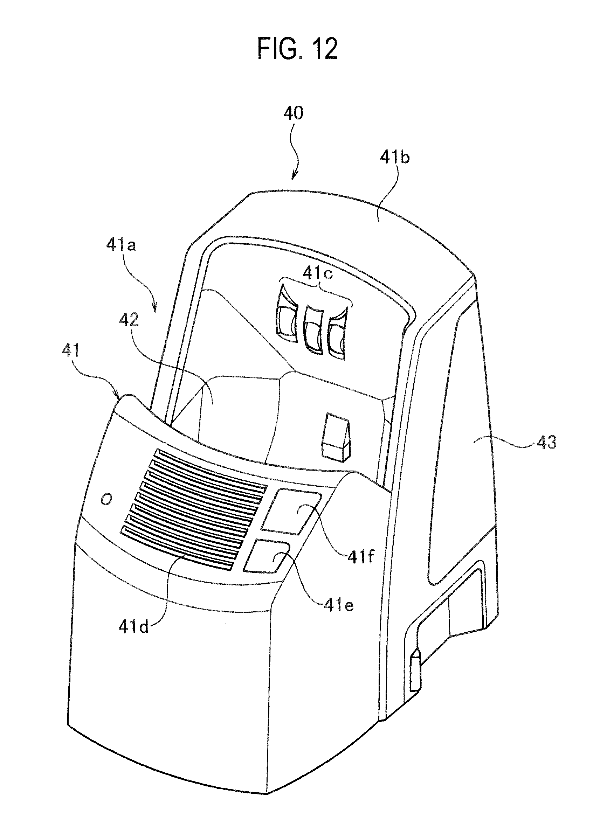

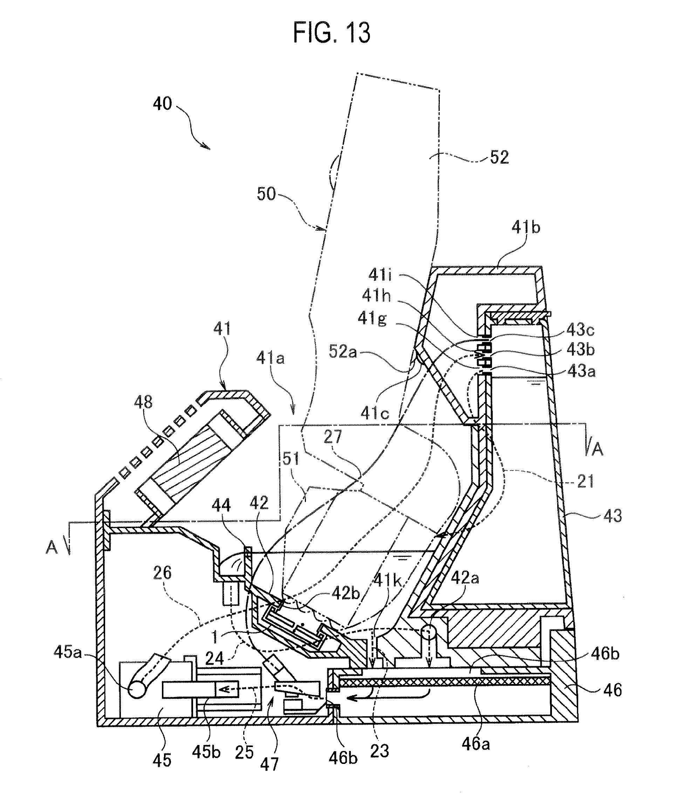

In the present embodiment, an example of a small-sized appliance using the plasma generator 1 will be explained with reference to FIG. 12 to FIG. 15. Hereinafter, a cleaning and purifying apparatus to clean a head unit of an electric shaver as a hair removing device will be exemplified.

A cleaning and purifying apparatus 40 as a small-sized appliance shown in FIG. 12 to FIG. 15 cleans a head unit (a cleaning treatment target section) 51 of an electric shaver 50 serving as a hair removing device.

As shown in FIG. 12 to FIG. 15, the cleaning and purifying apparatus 40 includes a case 41 having the opening 41a through which the electric shaver 50 with the head unit 51 directed downward is inserted, and a receiving plate 42 that receives the head unit 51 inserted through the opening 41a.

The cleaning and purifying apparatus 40 further includes a tank 43 that stores a liquid, an overflow section 44 that communicates with the receiving plate 42, and a pump 45 that cyclically supplies the liquid stored in the tank 43 to a liquid inlet 7. In addition, the cleaning and purifying apparatus 40 includes a cartridge 46 having a filter 46a for filtration of the liquid, an opening-closing valve 47 that controls the airtight state inside the tank 43, and a circulation path in which the liquid is circulated.

The circulation path includes a pipe (the liquid introduction passage) 21 to introduce the liquid stored in the tank 43 into the receiving plate 42, a path 23 (a discharge passage) to introduce the liquid discharged from the receiving plate 42 into the cartridge 46, a path 24 to introduce the liquid discharged from the overflow section 44 into the cartridge 46, a path 25 to introduce the liquid discharged from the cartridge 46 into the pump 45, and a path 26 to introduce the liquid delivered from the pump 45 into the tank 43. The opening-closing valve 47 is connected to the tank 43 via an airtight path 27. Next, the respective components are explained in detail below.

The case 41 includes a stand 41b coming into contact with the grip 52 of the electric shaver 50 on the back side, and holds the electric shaver 50 inserted from the opening 41a with the receiving plate 42. As shown in FIG. 12, the stand 41b is provided, on the front surface, with contact members 41c that detect the insertion of the electric shaver 50 in the cleaning and purifying apparatus 40 when a terminal 52a provided on the back surface of the grip 52 comes into contact with the contact members 41c. In addition to this detecting function, the electric shaver 50 has a function to output several control signals and driving power.

The case 41 houses a fan 48 in the front and upper portion to dry the head unit 51 after finishing cleaning. The case 41 is provided, on the front side, with a ventilation window 41d for the fan 48, an operation button 41e to start the cleaning operation, and a lamp 41f to indicate the operating state. The case 41 is provided with the tank 43 on the back side having connecting ports 41g, 41h and 41i each communicating with ports 43a, 43b and 43c, respectively. The connecting port 41g is connected to the pipe (the liquid introduction passage) 21, the connecting port 41h is connected to the path 26, and the connecting port 41i is connected to the airtight path 27.

The receiving plate 42 is a recess formed in a manner such that the head unit 51 fits therein, and is provided with a through-hole 42b on the bottom wall. The plasma generator 1 is provided on the back surface of the bottom wall of the receiving plate 42 in a manner such that the liquid storage section 4 communicates with the inner space of the receiving plate 42 through the through-hole 42b.

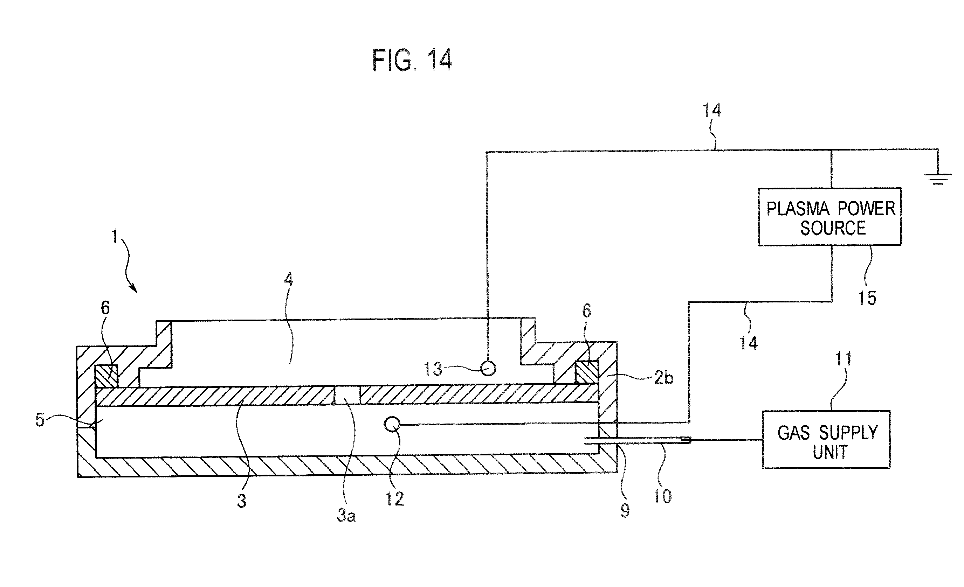

In the present embodiment, the plasma generator 1 is provided in a manner such that the liquid storage section 4 communicates with the inner space of the receiving plate 42, so that the inner space of the receiving plate 42 also functions as the liquid storage section 4 of the plasma generator 1. The receiving plate 42 may be preferably provided with a drain groove so as to discharge the liquid in the liquid storage section 4 from the path 23 (the discharge passage) more smoothly. In addition, a ring-shaped sealing member 6 is attached along the periphery of the liquid storage section 4 of the plasma generator 1 to seal the gap between the case member 2 and the ceramic member 3, so as to prevent the liquid 17 in the liquid storage section 4 from leaking from the gap between the case member 2 and the ceramic member 3 into the gas storage section 5 (refer to FIG. 14).

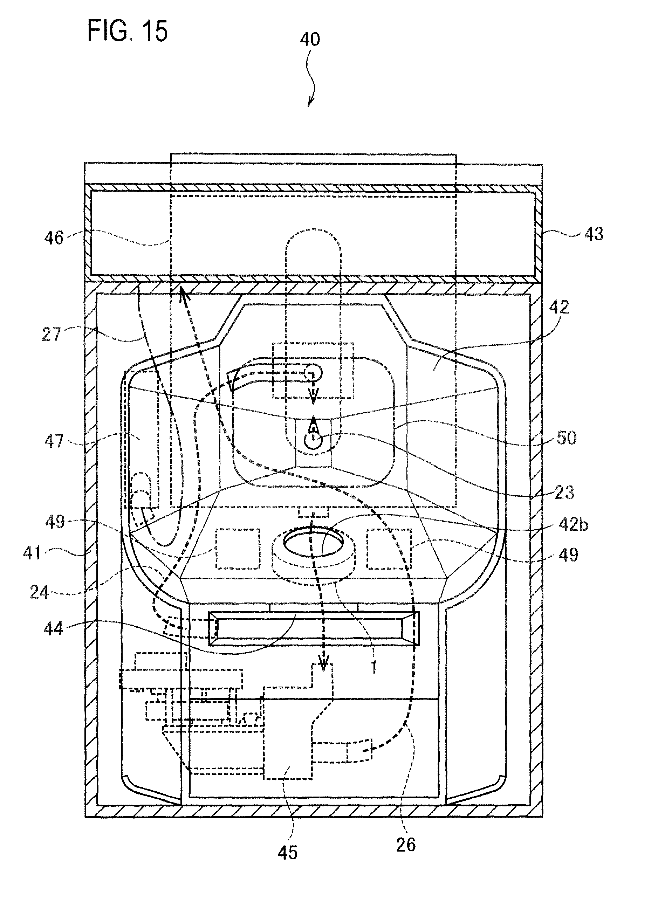

The receiving plate 42 is provided with heaters 49 on the back side of the bottom wall (refer to FIG. 15). The heaters 49 dry the head unit 51 in association with the fan 48.

The overflow section 44 is provided on the front side of the receiving plate 42. The receiving plate 42 and the overflow section 44 are integrally formed in the present embodiment. The inlet of the overflow section 44 is connected to the receiving plate 42, and the outlet of the overflow section 44 is connected to the path 24. The path 24 connects the outlet of the overflow section 44 to the cartridge 46 via a junction port 42a provided on the rear side of the receiving plate 42.

The tank 43 is provided, on the front surface, with the outflow port 43a, the inflow port 43b, and the ventilation port 43c to release the tank 43 from the airtight condition. The ventilation port 43c opens and closes to control liquid discharge from the outflow port 43a. The tank 43 is detachably provided on the back side of the case 41. When the tank 43 is attached to the case 41, the outflow port 43a is connected to the connecting port 41g to introduce the liquid stored in the tank 43 into the receiving plate 42 via the pipe (the liquid introduction passage) 21. The inflow port 43b is connected to the connecting port 41h to communicate with a delivery port 45a of the pump 45 via the path 26. The ventilation port 43c is connected to the connecting port 41i to communicate with the opening-closing valve 47 via the airtight path 27.

The cartridge 46 is formed into a substantially box shape that houses the filter 46a therein, and has an inflow port 46b on the upper side and an outflow port 46c on the front side. The cartridge 46 is detachably provided on the bottom and rear side of the case 41. When the cartridge 46 is attached to the case 41, the inflow port 46b is connected to the discharge port 42k via the path 23 (the discharge passage), and connected to the outlet of the overflow section 44 via the path 24. The outflow port 46c is connected to a suction port 45b of the pump 45 via the path 25.

The following is an explanation of the operation of the cleaning and purifying apparatus 20.

First, the liquid is introduced into the receiving plate 42 and the liquid storage section 4 of the plasma generator 1 from the tank 43 via the pipe (the liquid introduction passage) 21.

A gas containing oxygen based on air and having a predetermined flow rate is delivered from the gas supply unit 11 to the gas storage section 5 via the pipe (the gas introduction passage) 10. Once the gas storage section 5 is shifted to the positive pressure state, the gas starts to flow from the gas storage section 5 toward the liquid storage section 4 through the gas passage 3c.

Then, a predetermined voltage is applied between the first electrode 12 and the second electrode 13 so that electric discharge is caused between the first electrode 12 and the second electrode 13. This electric discharge (the discharge caused between the surface of the first electrode 12 in contact with the gas and the surface of the second electrode 13 in contact with the liquid) produces plasma in the gas region in the liquid 17 in the liquid storage section 4, and produces ozone and hydroxyl radical from water contained in the liquid 17 and oxygen contained in the gas (refer to FIG. 4).

The produced ozone and several types of radicals are delivered to the liquid stored in the liquid storage section 4 and the receiving plate 42 along with the gas flow described above. At this point, the gas bubbles being developed are separated from the opening end 3c and released into the liquid as the gas bubbles 16 finely separated by a micronizing means. The released fine gas bubbles 16 are dispersed in all directions in the liquid. Namely, the produced cleaning liquid is supplied to the head unit 51 serving as a cleaning treatment target section 30. The ozone or radical dissolved in the liquid (the cleaning liquid) and the ozone or radical contained in the gas bubbles 16 effectively dissolve the organic substances adhering to the head unit 51.

As described above, the cleaning and purifying apparatus (small-sized appliance) 40 according to the present embodiment includes the plasma generator 1. Namely, in the cleaning and purifying apparatus (small-sized appliance) 40 according to the present embodiment, a predetermined voltage is applied between the first electrode 12 and the second electrode 13 while the second electrode 13 is grounded. This configuration protects the user from electrical shock even if the user accidentally touches the liquid 17 or the second electrode 13, and is thus particularly suitable for the case where the second electrode 13 is exposed on the outside of the generator.

Accordingly, safe use of the small-sized appliance of the present embodiment can be reliably ensured.

The present embodiment may be applicable to the plasma generators 1A to 1F.

### (Third embodiment)

In the present embodiment, an example of a cleaning and purifying apparatus using a plasma generator will be explained below.

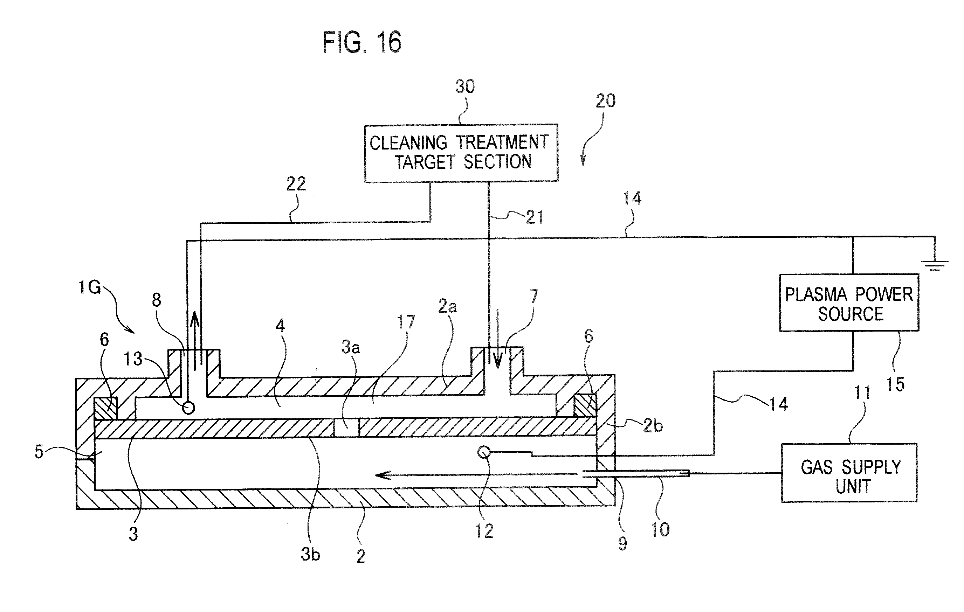

A cleaning and purifying apparatus 20 according to the present embodiment includes a plasma generator 1G as shown in FIG. 16.

The plasma generator 1G has substantially the same constitution as the plasma generator 1 according to the first embodiment. That is, the plasma generator 1G includes the case member 2, and the ceramic member (the partition) 3 provided inside of the case member 2 to divide it into the upper area and the lower area.

The upper area in the inner space of the case member 2 divided by the ceramic member 3 serves as the liquid storage section 4 to store the liquid 17 containing water, and the lower area serves as the gas storage section 5 to store the gas.

The ring-shaped sealing member 6 is attached along the periphery of the liquid storage section 4 to seal the gap between the case member 2 and the ceramic member 3, so as to prevent the liquid 17 in the liquid storage section 4 from leaking from the gap between the case member 2 and the ceramic member 3 into the gas storage section 5.

The plasma generator 1G according to the present embodiment differs from the plasma generator 1 according to the first embodiment in that the liquid inlet 7 is provided on the upper wall (the wall on the liquid storage section 4 side) 2a of the case member 2 to introduce the liquid 17 into the liquid storage section 4, and a liquid outlet 8 is provided on the upper wall 2a to discharge the liquid 17 introduced into the liquid storage section 4 to the outside.

In cleansing and purifying apparatus 20 according to the present embodiment, the pipe (the liquid introduction passage) 21 to introduce the treated liquid 17 from the cleaning treatment target section 30 into the liquid storage section 4, is connected to the liquid inlet 7 of the case member 2 that houses the ceramic member 3. In addition, a pipe (a liquid discharge passage) 22 to deliver the liquid inside the liquid storage section 4 to the cleaning treatment target section 30, is connected to the liquid outlet 8.

Next, the performance of the cleaning and purifying apparatus 20 is explained below.

As shown in FIG. 16, a gas containing oxygen based on air and having a predetermined flow rate is delivered from the gas supply unit 11 to the gas storage section 5 via the pipe (the gas introduction passage) 10. Once the gas storage section 5 is shifted to the positive pressure state, the gas starts to flow from the gas storage section 5 toward the liquid storage section 4 through the gas passage 3c.

At this point, the treated liquid 17 is introduced from the cleaning treatment target section 30 into the liquid storage section 4 through the pipe (the liquid introduction passage) 21 and the liquid inlet 7.

Then, a predetermined voltage is applied between the first electrode 12 and the second electrode 13 while the second electrode 13 is grounded so that electric discharge is caused between the first electrode 12 and the second electrode 13. This electric discharge (the discharge caused between the surface of the first electrode 12 in contact with the gas and the surface of the second electrode 13 in contact with the liquid) produces plasma in the gas region in the liquid 17 in the liquid storage section 4, and produces ozone and hydroxyl radical from water contained in the liquid 17 and oxygen contained in the gas (refer to FIG. 4).

The produced ozone and several types of radicals are delivered to the liquid storage section 4 along with the gas flow. At this point, the gas bubbles being developed are separated by the flow of the liquid 17, and released into the liquid as the fine gas bubbles 16.

The fine gas bubbles 16 released into the liquid are dispersed in all directions. A number of the dispersed fine gas bubbles 16 are easily dissolved in the liquid 17 together with the ozone and hydroxyl radical contained in the gas bubbles 16, and the ozone concentration is thus increased. In addition, a number of the gas bubbles 16 containing the ozone and hydroxyl radical easily adhere to the organic substance contained in the liquid 17. Further, fine organic substances adhere to a number of the gas bubbles 16.

The ozone or radical dissolved in the liquid 17, or the ozone or radical contained in the gas bubbles 16 adhering to the organic substances, thus effectively resolves the organic substances in the liquid 17. The cleaned liquid 17 in which the organic substances are resolved returns to the cleaning treatment target section 30 from the liquid outlet 8 through the pipe (the liquid discharge passage) 22 so as to be reused.

The cleaning and purifying apparatus 20 described above was exemplified by a usage mode (usage mode A) in which the liquid 17 is cleaned and purified inside the case member 2. Alternatively, another usage mode (usage mode B), such as the second embodiment, in which the liquid 17 containing the fine gas bubbles dispersed therein is supplied to a predetermined device as a cleaning liquid, may also be applicable to the present embodiment.

In the latter case, the cleaning and purifying apparatus 20 operates as follows.

First, the fine gas bubbles 16 containing the ozone and hydroxyl radical are dispersed in the liquid 17 introduced into the case member 2, and the ozone and hydroxyl radical contained in the fine gas bubbles 16 are thus dissolved in the liquid 17. At this point, fine organic substances adhere to a number of the gas bubbles 16.

Then, the liquid 17 is supplied as a cleaning liquid to the cleaning treatment target section 30. In the cleaning treatment target section 30, the organic substances are effectively resolved by the ozone or radical dissolved in the liquid 17, or by the ozone or radical contained in the gas bubbles 16 adhering to the organic substances.

In the case of using the cleaning and purifying apparatus in usage mode A, the cleaning and purifying apparatus may be used for purification of various types of liquids such as warm water stored in bathtubs, rainwater, foul water and sewage water. In the case of usage mode B, the liquid 17 is water acting as a purifying liquid used for, for example, various types of appliances such as a washing machine and a dishwasher, health appliances such as a mouthwashing device, and sanitary appliances such as a lavatory basin. In addition to these appliances, a wide variety of industrial applications such as washing of food and cleaning of industrial products in manufacturing processes may be possible.

As explained above, in the present embodiment, the cleaning and purifying apparatus 20 includes the plasma generator 1G. Accordingly, safe use of the cleaning and purifying apparatus 20 can be more reliably ensured.

The present embodiment may be applicable to the plasma generators 1A to 1F.

### (Fourth embodiment)

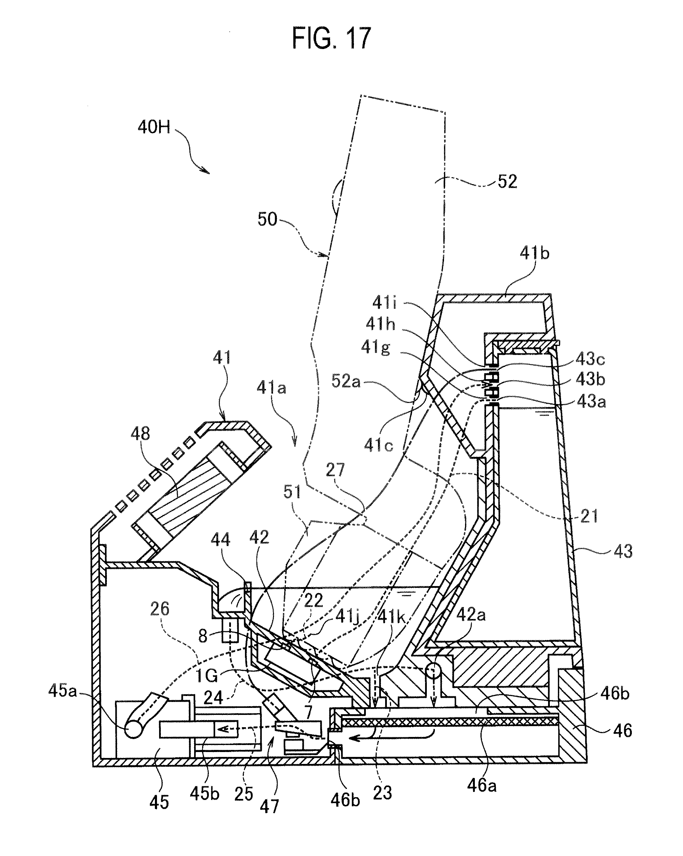

In the present embodiment, an example of a small-sized appliance using the plasma generator 1G will be explained with reference to FIG. 17. Hereinafter, a cleaning and purifying apparatus to clean a head unit of an electric shaver as a hair removing device will be exemplified.

A cleaning and purifying apparatus 40H as a small-sized appliance shown in FIG. 17 cleans the head unit 51 of the electric shaver 50 serving as a hair removing device. The cleaning and purifying apparatus 40H is used in usage mode B. The head unit 51 of the electric shaver 50 corresponds to the cleaning treatment target section 30.

The cleaning and purifying apparatus 40H has substantially the same configuration as the cleaning and purifying apparatus 40 according to the second embodiment, and includes the case 41 having the opening 41a through which the electric shaver 50 with the head unit 51 directed downward is inserted, and the receiving plate 42 that receives the head unit 51 inserted through the opening 41a (refer to FIG. 17).

The cleaning and purifying apparatus 40H further includes the tank 43 that stores a liquid, the overflow section 44 that communicates with the receiving plate 42, and the pump 45 that cyclically supplies the liquid stored in the tank 43 to the liquid inlet 7. In addition, the cleaning and purifying apparatus 40 includes the cartridge 46 having the filter 46a for filtration of the liquid, the opening-closing valve 47 that controls the airtight state inside the tank 43, and the circulation path in which the liquid is circulated.

The circulation path includes the pipe (the liquid introduction passage) 21 to introduce the liquid stored in the tank 43 into the liquid inlet 7, the pipe (a liquid discharge passage) 22 to introduce the liquid discharged from the liquid outlet 8 into the receiving plate 42, the path 23 (the discharge passage) to introduce the liquid discharged from the receiving plate 42 into the cartridge 46, the path 24 to introduce the liquid discharged from the overflow section 44 into the partridge 46, the path 25 to introduce the liquid discharged from the cartridge 46 into the pump 45, and the path 26 to introduce the liquid delivered from the pump 45 into the tank 43 .

The receiving plate 42 is a recess formed in a manner such that the head unit 51 fits therein, and is provided with the plasma generator 1G on the back side of the bottom wall. The cleaning and purifying apparatus 40H may be provided with a position adjuster that adjusts the position of the plasma generator 1G. For example, the receiving plate 42 may be provided, on the back side of the bottom wall, with an arm member to which the plasma generator 1G is swingably fixed so that the position adjuster can adjust and place the plasma generator 1G in a horizontal position. This contributes to constantly keeping the plasma generator 1 in the horizontal position and thereby producing the plasma more stably.

The plasma generator 1G includes the liquid inlet 7 connected to the pipe (the liquid introduction passage) 21, and the liquid outlet 8 connected to the pipe (a liquid discharge passage) 22. The bottom wall of the receiving plate 42 is provided with a supply port 41j connected to the pipe (the liquid discharge passage) 22 and a discharge port 41k connected to the path 23.

The overflow section 44 is provided on the front side of the receiving plate 42 . The receiving plate 42 and the overflow section 44 are integrally formed in the present embodiment. The inlet of the overflow section 44 is connected to the receiving plate 42, and the outlet of the overflow section 44 is connected to the path 24. The path 24 connects the outlet of the overflow section 44 to the cartridge 46 via the junction port 42a provided on the rear side of the receiving plate 42.

The tank 43 is provided, on the front surface, with the outflow port 43a, the inflow port 43b, and the ventilation port 43c to release the tank 43 from the airtight condition. The ventilation port 43c opens and closes to control liquid discharge from the outflow port 43a. The tank 43 is detachably provided on the back side of the case 41. When the tank 43 is attached to the case 41, the outflow port 43a is connected to the connecting port 41g via the pipe (the liquid introduction passage) 21 so as to communicate with the liquid inlet 7 of the plasma generator 1G. The inflow port 43b is connected to the connecting port 41h via the path 26 so as to communicate with the delivery port 45a of the pump 45. The ventilation port 43c is connected to the connecting port 41i via the airtight path 27 so as to communicate with the opening-closing valve 47.

Accordingly, the cleaning liquid produced in a manner such that the fine gas bubbles 16 containing the ozone and hydroxyl radical are dispersed into the liquid introduced into the plasma generator 1G from the tank 43, is supplied to the receiving plate 42 from the connecting port 41j. Namely, the produced cleaning liquid is supplied to the head unit 51 serving as the cleaning treatment target section 30. Accordingly, the ozone or radical dissolved in the liquid (the cleaning liquid), or the ozone or radical contained in the gas bubbles 16 can effectively resolve the organic substances adhering to the head unit 51.

As explained above, in the present embodiment, the cleaning and purifying apparatus (the small-sized appliance) 40H includes the plasma generator 1G. Accordingly, safe use of the small-sized appliance can be reliably ensured.

When the position adjuster that adjusts the position of the plasma generator 1G is provided in the cleaning and purifying apparatus (the small-sized appliance) 40H, the plasma can be stabilized more reliably.

Note that the present invention may provide a cleaning and purifying apparatus (a small-sized appliance) using the case member 2 having the configuration of the plasma generator 1G, and using any of the plasma generators 1A to 1F.

Although the present invention has been described above by reference to the preferred embodiments, the present invention is not limited to the descriptions thereof, and it will be apparent to those skilled in the art that various modifications and improvements can be made.

Although the respective embodiments use the ceramic member as the partition provided with the gas passage, the partition is not limited to the ceramic member. For example, the partition may be obtained in such a manner that an arbitrary member such as a glass plate to separate a gas from a liquid is prepared, and it is then subjected to photoengraving and etching processing so as to have fine pores approximately in the range from 1 µm to 10 µm. The partition may be provided with plural gas passages.

The cleaning and purifying apparatus and the small-sized appliance are not particularly limited to those in the respective embodiments described above. For example, the present invention is applicable to, for example, a cleaning and purifying apparatus for an electrical toothbrush, a water filtration apparatus, and an apparatus for purifying water containing detergents before discharging.

The liquid storage section, the gas storage section and the other particular specs (such as a shape, size and layout) can also be changed as necessary.

### INDUSTRIAL APPLICABILITY

The present invention can provide a plasma generator capable of surely ensuring safety, and a cleaning and purifying apparatus and a small-sized electrical appliance using the plasma generator.

## Claims

1. A plasma generator, comprising:
a liquid storage section that stores a liquid containing water;
a gas storage section that stores a gas;
a partition provided with a gas passage to introduce the gas in the gas storage section into the liquid storage section, and separating the liquid storage section from the gas storage section;
a first electrode provided in the gas storage section;
a second electrode separated from the first electrode and provided in a manner such that at least a portion coupled with the first electrode is in contact with the liquid in the liquid storage section;
a gas supply unit that supplies a gas containing oxygen to the gas storage section so that the gas in the gas storage section is delivered under pressure into the liquid storage section via the gas passage; and
a plasma power source that applies a predetermined voltage between the first electrode and the second electrode while the second electrode is grounded to cause electric discharge between the first electrode and the second electrode, and thereby convert the gas introduced into the gas storage section into plasma.

2. The plasma generator according to claim 1, wherein more than one gas passage is provided in the partition.

3. The plasma generator according to claim 2, wherein the first electrode is placed to be substantially an identical distance from each gas passage.

4. The plasma generator according to any one of claims 1 to 3, wherein the first electrode is composed of a single structure.

5. The plasma generator according to claim 4, wherein the first electrode composed of a single structure is placed in direct contact with the partition on the gas storage section side.

6. The plasma generator according to any one of claims 1 to 4, wherein the first electrode is located on an axis of the gas passage so as to face the gas passage.

7. A cleaning and purifying apparatus comprising the plasma generator according to any one of claims 1 to 6.

8. A small-sized appliance comprising the plasma generator according to any one of claims 1 to 6.

9. A small-sized appliance comprising the cleaning and purifying apparatus according to claim 7.

## Amended claims

### Amended claims under Art. 19.1 PCT

**1.** Currently amended) A plasma generator, comprising:
a liquid storage section that stores a liquid containing water;
a gas storage section that stores a gas;
a partition provided with a gas passage to introduce the gas in the gas storage section into the liquid storage section, and separating the liquid storage section from the gas storage section;
a first electrode provided in the gas storage section;
a second electrode separated from the first electrode and provided in a manner such that at least a portion coupled with the first electrode is in contact with the liquid in the liquid storage section;
a gas supply unit that supplies a gas containing oxygen to the gas storage section so that the gas in the gas storage section is delivered under pressure into the liquid storage section via the gas passage; and
a plasma power source that applies a predetermined voltage between the first electrode and the second electrode while the second electrode is grounded to cause electrical discharge between the first electrode and the second electrode, and thereby convert the gas introduced into the gas storage section into plasma,
wherein the first electrode is composed of a single structure,
the first electrode composed of a single structure is placed in direct contact with the partition on the gas storage section side, and
the electrode is provided with a deep counterbore corresponding to the gas passages in a concentric manner and having a larger diameter than the gas passage.

**2.** The plasma generator according to claim 1, wherein more than one gas passage is provided in the partition.

**3.** The plasma generator according to claim 2, wherein the first electrode is placed to be substantially an identical distance from each gas passage.

**4.** Currently amended) A cleaning and purifying apparatus comprising the plasma generator according to any one of claims 1 to 3.

**5.** Currently amended) A cleaning and purifying apparatus comprising the plasma generator according to any one of claims 1 to 3.

**6.** Currently amended) A small-sized appliance comprising the cleaning and purifying apparatus according to claim 4.

**7.** Canceled)

**8.** (Canceled)

**9.** Canceled)
